# EUROPÄISCHE PATENTSCHRIFT

(11) **EP 2 079 107 B1**
(45) Veröffentlichungstag und Bekanntmachung des Hinweises auf die Patenterteilung: **18.10.2017**
(21) Anmeldenummer: 08405006.1
(22) Anmeldetag: 10.01.2008
(51) Int. Cl.: H01L 23/498

(54) **Verfahren zum Herstellen eines kartenförmigen Datenträgers und nach diesem Verfahren hergestellter Datenträger**
Method for manufacturing a card-shaped data carrier and data carrier manufactured by means of this method
Procédé destiné à la fabrication d'un support de données en forme de carte et support de données fabriqué selon ce procédé

(43) Veröffentlichungstag der Anmeldung: 15.07.2009
(73) Patentinhaber: Gemalto AG, 5000 Aarau (CH)
(72) Erfinder: Hahn, Roland, 4600 Oten (CH)
(74) Vertreter: Frischknecht, Harry Ralph

(56) Entgegenhaltungen:
- DE-A1- 3 248 385
- JP-A- 11 175 682

## Beschreibung

Die Erfindung betrifft ein Verfahren zum Herstellen eines kartenförmigen Datenträgers nach dem Oberbegriff des Anspruchs 1. Die Erfindung betrifft zudem einen kartenförmigen Datenträger der nach diesem Verfahren hergestellt wurde.

Verfahren zum Herstellen von kartenförmigen Datenträgern mit eingebautem Modul sind aus der DE 102 57 111 A und der WO 2005/063909 bekannt geworden. Mit diesem Verfahren können kartenförmige Datenträger, beispielsweise Kreditkarten, Kundenkarten, Zutrittskarten oder auch Ausweise beispielsweise für die Passkontrolle hergestellt werden. Das in die Ausnehmung eingesetzte Modul ist beispielsweise ein Chip-Modul, das Modulanschlüsse für den elektrischen Kontakt zu einer Antenne besitzt, welche sich im Kartenkörper befindet. Solche Antennen sind an sich bekannt und können beispielsweise gedruckt, geätzt, gewickelt oder gelegt sein. In der Regel befindet sich diese Antenne zwischen zwei Folien oder Schichten des Kartenkörpers. Das Modul kann beispielsweise einen Schaltkreis aufweisen, der als RFID-Transponder ausgebildet ist und eine berührungslose Erkennung ermöglicht. Grundsätzlich sind hier aber auch andere Module und insbesondere elektronische Module denkbar.

Damit das Modul in den Kartenkörper implantiert werden kann, wird eine Folie mit einer Ausnehmung versehen, in dem diese beispielsweise ausgestanzt wird. In diese Ausnehmung bzw. Ausstanzung wird das Implantat mit einer geeigneten Vorrichtung eingesetzt und elektrisch mit der Antenne verbunden. Zudem wird das Modul beispielsweise mit einem geeigneten Kleber in der Ausnehmung befestigt. Damit dieses Einsetzen oder Implantieren einfach und sicher erfolgen kann, muss die Ausnehmung eine bestimmte Toleranz zum Modul aufweisen. Diese Toleranz hat zur Folge, dass beim eingesetzten Modul zwischen diesem und dem Rand der Ausnehmung ein spaltförmiger Zwischenraum besteht. Ein solcher Zwischenraum ist jedoch nachteilig, da er bei der späteren Kartenherstellung im Drucklayout ein nicht akzeptables Verfliessen verursachen kann. Zudem kann ein solcher Zwischenraum bzw. Spalt auch eine Deformation im Kartenkörper verursachen. Um diese Nachteile zu vermeiden, ist ein Verfahren bekannt geworden, bei dem der Spalt mit einer geeigneten Paste gefüllt wird. Nach einem anderen Verfahren wird ein Halbfabrikat bzw. Inlet hergestellt, das nach dem Einsetzen des Moduls mit weiteren Folien laminiert wird. Beide Verfahren bedingen aber vergleichsweise aufwändige weitere Schritte zum Herstellen eines kartenförmigen Datenträgers der genannten Art.

Die JP 11-175682 offenbart ein Verfahren zum Herstellen eines Datenträgers, wobei das elektronische Modul in eine Schicht aus einem Schmelzklebstoff (hot-melt adhesive) eingesetzt wird. Nachher wird eine Deckfolie mit einer Klebstoffschicht aufgelegt und diese unter Druck und erhöhter Temperatur mit der Schicht aus dem Schmelzklebstoff verklebt. Die Klebstoffe umfliessen das Modul und schliessen dieses ein. Schliesslich wird der Datenträger geschnitten.

Der Erfindung liegt die Aufgabe zugrunde, ein Verfahren der genannten Art zu schaffen, das die erwähnten Nachteile vermeidet. Die Aufgabe ist bei einem gattungsgemässen Verfahren gemäss Anspruch 1 gelöst. Ein solches Erwärmen und Verdichten kann wesentlich einfacher und schneller durchgeführt werden als das erwähnte Herstellen eines Vorlaminates oder das Verfüllen mit einer Paste. Insbesondere kann dieses Erwärmen und Verdichten unmittelbar nach der Herstellung der Antenne bei einer Inlineproduktion erfolgen. Das erfindungsgemässe Verfahren kann somit im wesentlichen ebenso effizient und kostengünstig durchgeführt werden wie ein Verfahren, bei dem der genannte Zwischenraum nicht eliminiert wird. Ein wesentlicher Vorteil des erfindungsgemässen Verfahrens wird darin gesehen, dass das Aussenformat stabil bleibt. Das bisher notwenige nachträgliche Beschneiden ist deshalb nicht erforderlich. Vorteilhaft ist zudem, dass geschweisste Garnituren wie Vorlaminate sehr einfach weiterverarbeitet werden können, da das Modul eingebettet ist und die Garnituren aufgrund der Verdichtung zusammengehalten werden.

Das Verfahren ist dann besonders kostengünstig, wenn das Erwärmen und Verdichten der Folie mit einem Stempel erfolgt, der ein Schweisswerkzeug bildet. Dieses Schweisswerkzeug ist insbesondere als Sonotrode ausgebildet und erwärmt somit die Folie mittels Ultraschall. Versuche haben gezeigt, dass mit der Verwendung von Ultraschall die Qualität besonders hoch ist und die Folie zudem sehr schnell erwärmt und verdichtet werden kann.

Vorzugsweise wird nach einer Weiterbildung der Erfindung das Modul in wenigstens zwei aneinander anliegende Folie eingesetzt. Jede dieser Folie besitzt eine entsprechende Ausnehmung für das Modul. Nach einer Weiterbildung der Erfindung werden zwei Folien ausgestanzt und nach dem Einlegen des Moduls wird zudem eine obere und eine untere Folie an diese beiden Folien angelegt. Anschliessend wird um das Modul herum erwärmt und verdichtet, so dass sich der Zwischenraum bzw. der Spalt um das Modul herum schliesst. Wie erwähnt wird lediglich um das Modul herum erwärmt und verdichtet. Bei der Herstellung des Datenträgers ist dann im Bereich des Chipmoduls kein Verzug im Druckbild zu erkennen.

Der erfindungsgemässe kartenförmige Datenträger ist dadurch gekennzeichnet, dass der Kartenkörper im Inneren um das Modul herum verdichtet ist. Bei diesem kartenförmigen Datenträger besteht somit kein Zwischenraum zwischen dem Umfang des Moduls und dem Kartenkörper. Bei einem solchen Datenträger kann eine Folie mit dem Modul an seinem Umfang verschweisst sein. Vorzugsweise ist ein solcher Datenträger mehrschichtig.

Weitere Merkmale und Vorteile ergeben sich aus den abhängigen Patentansprüchen, der nachfolgenden Beschreibung sowie der Zeichnungen.

Ausführungsbeispiele der Erfindung werden nachfolgend anhand der Zeichnung näher erläutert. Es zeigen:
- Figur 1: schematisch ein Schnitt durch einen Teil eines kartenförmigen Halbfabrikat für einen Datenträger sowie ein Werkzeug zum Erwärmen und Verdichten des Kartenkörpers lokal um ein eingesetztes Modul herum,
- Figur 2: schematisch das Einsetzen eines Moduls in ein Halbfabrikat und
- Figur 3: schematisch eine Draufsicht auf das Halbfabrikat.
- Figur 4: schematisch ein Schnitt durch einen Teil eines erfindungsgemässen Datenträgers.

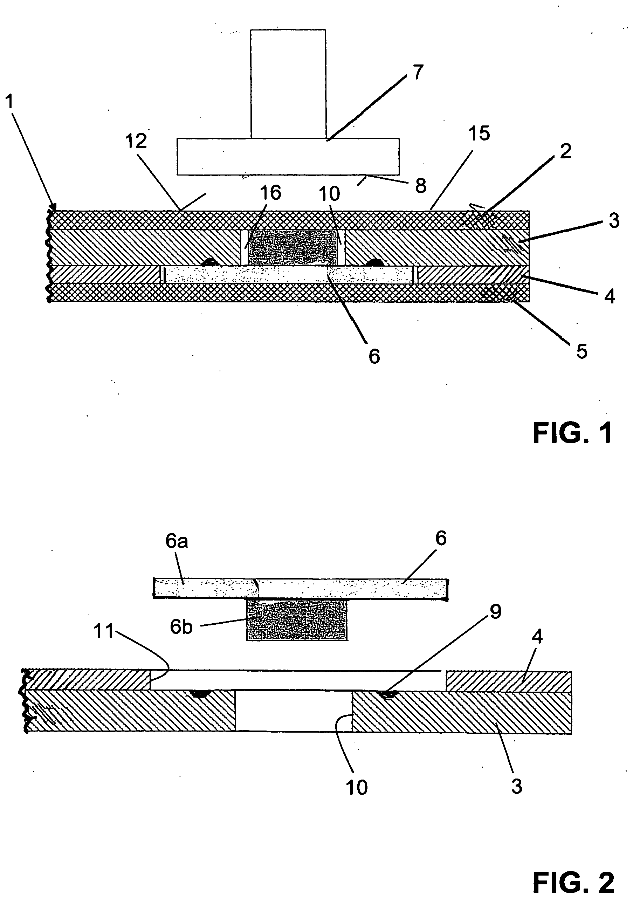

Die Figur 1 zeigt einen Abschnitt eines kartenförmigen Halbfabrikat 1, der einen Kartenkörper 15 aufweist, in den ein elektronisches Modul 6 implantiert ist. Solche Halbfabrikate 1 werden auch "Inlets" oder "Inlays" genannt. Dieses Modul 6 ist üblicherweise aber nicht zwingend wie gemäss Figur 2 aus einem plattenförmigen Träger 6a und einem Kopf 6b ausgebildet. Das Modul 6 ist insbesondere ein Chip-Modul. Beim Implantieren wird dieses Modul 6 mit einer Antenne 9 elektrisch verbunden. Zudem wird das Modul 6 beispielsweise mit einem Flüssigkleber, einem Heisskleber (Hotmelt) oder einer Klebefolie im Kartenkörper 15 befestigt.

Beim gezeigten Halbfabrikat 1 ist das Modul 6 in eine erste Ausgleichsfolie 3 und eine zweite Ausgleichsfolie 4 eingesetzt. Die erste Ausgleichsfolie 3 besitzt eine Ausnehmung 10, die beispielsweise eine rechteckige oder runde Ausstanzung ist, welche den Kopf 6b des Moduls 6 aufnimmt. Die zweite Ausgleichsfolie 4 besitzt eine grössere Ausnehmung 11 entsprechend dem plattenförmigen Träger 6a. Die Ausnehmung 10 ist so dimensioniert, dass nach dem Einsetzen des Moduls 6 zwischen diesem und der ersten Ausgleichsfolie 3 ein spaltförmiger Zwischenraum 16 vorhanden ist, wie dies in Figur 1 gezeigt ist. Ein solcher Spalt kann auch in der Ausnehmung 11 vorhanden sein. Die Dicke des Moduls 6 entspricht der Summe der beiden Dicken der Ausgleichsfolien 3 und 4.

Das Modul 6 wird, wie in Figur 2 gezeigt in die Ausnehmungen 10 und 11 eingesetzt. Anschliessend wird an der zweiten Ausgleichsfolie 4 eine untere Folie 5 und an der Ausgleichsfolie eine obere Folie 2 positioniert, so dass schliesslich die Anordnung gemäss Figur 1 vorliegt. Mit einer Sonotrode 7 wird nun gemäss Figur 1 der Kartenkörper 15 im Bereich des Moduls 6 erwärmt und verdichtet. Der Bereich entspricht im wesentlichen demjenigen einer ebenen Frontseite 8 der Sonotrode 7. Die Sonotrode 7 wird mit der Frontseite 8 an eine Fläche 12 des Kartenkörpers 15 angelegt. Durch die in den Kartenkörper 15 eingeleitete Ultraschallenergie wird der Kartenkörper um das Modul 6 herum erwärmt und verdichtet. Eine geeignete Schwingungsfrequenz liegt vorzugsweise im Bereich von 20 - 40 kHz. Der erwärmte Kartenkörper 15 wird dadurch fliessfähig und schliesst dadurch den spaltförmigen Zwischenraum 16. Da das Volumen des Zwischenraumes 6 vergleichsweise klein ist, sind die übrigen Deformationen am Kartenkörper 15 sehr gering. Nach diesem Verfahrensschritt ist der Zwischenraum 16 somit nicht mehr vorhanden. Wesentlich ist, dass dieses Erwärmen und Verdichten mittels der Sonotrode 7 sehr schnell erfolgen kann. Der übliche vollautomatische Inlineprozess zum Herstellen eines Datenträgers 18 wird dadurch nicht oder nur unwesentlich verlangsamt. Das Erwärmen und Verdichten mittels der genannten Sonotrode 7 ist lediglich ein Beispiel. Denkbar ist auch ein Erwärmen und Verdichten mit einem Heizelement oder mit heisser Luft.

Der gezeigte Kartenkörper 15 besteht aus mehreren Schichten 2-5. Er kann aber auch aus lediglich einer Schicht bestehen. Insbesondere ist die oberste Folie 2 nicht zwingend. Diese kann somit auch weggelassen werden.

Der Kartenkörper 15 und somit die Folien 2, 3, 4 und 5 bestehen jeweils aus einem geeigneten Kunststoff, insbesondere einem thermoplastischen Kunststoff, wie dies bei solchen Datenträgern 18 üblich ist.

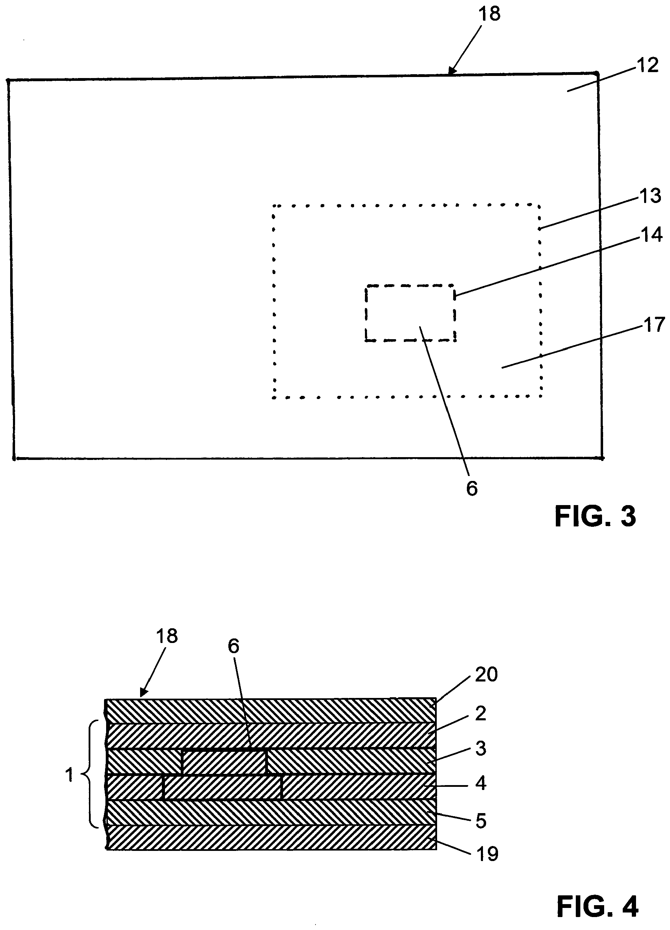

Ist das Halbfabrikat 1 mit dem Kartenkörper 15 hergestellt, so wird dieses beispielsweise mit zwei Folien 19 und 20 laminiert. Die Figur 4 zeigt einen Schnitt durch einen Teil des Datenträgers 18, der durch Laminieren des Halbfabrikats 1 mit den Folien 19 und 20 hergestellt wurde. Für den Fachmann ist klar, dass mit noch weiteren hier nicht gezeigten Folien laminiert werden kann, wobei diese bedruckt, transparent oder opak sein können.

Die Figur 3 zeigt eine Draufsicht auf den Datenträger 18. Das implantierte Modul 6 ist hier mit gestrichelten Linien 14 und der im Inneren des Kartenkörpers verdichtete Bereich 17 mit punktierten Linien 13 dargestellt. Der verdichtete Bereich 17 ist hier somit rechteckig und umgibt den Chip 6 rahmenförmig. Dieser Bereich 17 kann selbstverständlich auch etwas grösser oder kleiner sein. Er ist aber jedenfalls ein Teilbereich der gesamten Fläche 12 des Datenträgers 18. Der Bereich 17 könnte selbstverständlich auch eine andere Form aufweisen, er könnte beispielsweise auch kreisrund oder oval sein.

### Bezugszeichenliste

- 1: Halbfabrikat
- 2: Obere Folie
- 3: erste Ausgleichsfolie
- 4: zweite Ausgleichsfolie
- 5: untere Folie
- 6: Modul
- 6a: Träger
- 6b: Kopf
- 7: Sonotrode
- 8: Frontseite
- 9: Antenne
- 10: Ausnehmung
- 11: Ausnehmung
- 12: Fläche
- 13: Linie
- 14: Linie
- 15: Kartenkörper
- 16: Zwischenraum
- 17: Bereich
- 18: Datenträger
- 19: Folie
- 20: Folie

## Patentansprüche

1. Verfahren zum Herstellen eines kartenförmigen Datenträgers, wobei zunächst ein Halbfabrikat hergestellt wird, das nach Einsetzen eines elektronischen Moduls (6) mit weiteren Folien laminiert wird, wobei das Halbfabrikat (1) wenigstens eine aus Kunststoff hergestellte Folie (3, 4) besitzt, die eine Ausnehmung (10, 11) aufweist, wobei das Modul (6) in dieser Ausnehmung (10, 11) angeordnet ist, wobei die Ausnehmung (10, 11) so hergestellt wird, dass nach dem Einsetzen des Moduls (6) in die Ausnehmung (10, 11) zwischen dem Umfang des Moduls (6) und der Ausnehmung (10, 11) ein Zwischenraum (16) verbleibt, **dadurch gekennzeichnet, dass** zum Herstellen des Halbfabrikats (1) nach dem Einsetzen des Moduls (6) in die Ausnehmung (10, 11) die wenigstens eine Folie (3, 4) lediglich lokal um das Modul (6) herum erwärmt und verdichtet wird, so dass die wenigstens eine Folie (3, 4) den Zwischenraum (16) schliesst.

2. Verfahren nach Anspruch 1, **dadurch gekennzeichnet, dass** die wenigstens eine Folie (3, 5) mittels eines Stempels (7) erwärmt wird.

3. Verfahren nach Anspruch 1 oder 2, **dadurch gekennzeichnet, dass** die wenigstens eine Folie (3, 4) mittels Ultraschall erwärmt wird.

4. Verfahren nach einem der Ansprüche 1 bis 3, **dadurch gekennzeichnet, dass** das Modul (6) in wenigstens zwei Folien (3, 4) eingesetzt wird, die jeweils eine Ausnehmung (10, 11) für das Modul (6) aufweisen.

5. Verfahren nach einem der Ansprüche 1 bis 4, **dadurch gekennzeichnet, dass** nach dem Einsetzen des Moduls (6) an der wenigstens einen Folie (3, 4) wenigstens eine weitere Folie (2) und insbesondere zwei weitere Folien (2, 5) positioniert wird bzw. werden.

6. Kartenförmiger Datenträger mit einem Kartenkörper (15) und einem in diesen implantieren Modul (6) hergestellt nach einem der Ansprüche 1 bis 5, **dadurch gekennzeichnet, dass** der Kartenkörper (15) im Inneren um das Modul (6) verdichtet ist.

7. Kartenförmiger Datenträger nach Anspruch 6, **dadurch gekennzeichnet, dass** das Modul in zwei miteinander verbundenen Folien (3, 4) eingesetzt ist.

8. Kartenförmiger Datenträger nach Anspruch 6, **dadurch gekennzeichnet, dass** er mehrschichtig ist und dass das Modul (6) von wenigstens einer Folie (2) abgedeckt ist.

## Claims

1. Method for producing a card-type data carrier, wherein initially a semifinished product is manufactured, which is laminated, after inserting of an electronic module (6), with further films, the semifinished product (1) has at least one film (3, 4) made from plastics, which has a cutout (10, 11), wherein the module (6) is arranged in said cutout (10, 11), the cutout (10, 11) being produced such that an interspace (16) remains between the periphery of the module (6) and the cutout (10, 11) after the module (6) has been inserted into the cutout (10, 11), **characterized in that** for producing the semifinished product (1), after the module (6) has been inserted into the cutout (10, 11), the at least one film (3, 4) is only locally heated and densified around the module (6), such that the at least one film (3, 4) closes the interspace (16).

2. Method according to claim 1, **characterized in that** the at least one film (3, 5) is heated by means of a stamp (7).

3. Method according to claim 1 or 2, **characterized in that** the at least one film (3, 4) is heated by means of ultrasound.

4. Method according to any of claims 1 to 3, **characterized in that** the module (6) is inserted in at least two films (3, 4) having a respective cutout (10, 11) for the module (6).

5. Method according to any of claims 1 to 4, **characterized in that** after the module (6) has been inserted, at least one further film (2), and in particular two further films (2, 5), is (are) positioned at the at least one film (3, 4).

6. Card-type data carrier having a card body (15) and a module (6) implanted into the latter, produced according to any of claims 1 to 5, **characterized in that** the card body (15) is densified in the interior around the module (6).

7. Card-type data carrier according to claim 6, **characterized in that** the module is inserted in two films (3, 4) connected to one another.

8. Card-type data carrier according to claim 6, **characterized in that** it is multilayered, and **in that** the module (6) is covered by at least one film (2).

## Revendications

1. Procédé de fabrication d'un support de données en forme de carte, où dans un premier temps un produit semi-fini est fabriqué, qui est laminé à des feuilles supplémentaires après l'insertion d'un module électronique (6), où le produit semi-fini comporte au moins une feuille fabriquée en matière plastique (3, 4) qui présente un évidement (10, 11), où le module (6) est disposé dans cet évidement (10, 11), où l'évidement (10, 11) est réalisé de telle sorte qu'après l'insertion du module (6) dans l'évidement (10, 11) entre la périphérie du module (6) et l'évidement (10, 11), il reste un espace intermédiaire (16), **caractérisé en ce que** pour la fabrication du produit semi-fini (1), après l'insertion du module (6) dans l'évidement (10, 11), l'au moins une feuille (3, 4) est chauffée et comprimée seulement localement autour du module (6), de telle sorte que l'au moins une feuille (3, 4) ferme l'espace intermédiaire (16).

2. Procédé selon la revendication 1, **caractérisé en ce que** l'au moins une feuille (3, 5) est chauffée au moyen d'un cachet (7).

3. Procédé selon la revendication 1 ou 2, **caractérisé en ce que** l'au moins une feuille (3, 4) est chauffée au moyen d'ultrasons.

4. Procédé selon l'une quelconque des revendications 1 à 3, **caractérisé en ce que** le module (6) est inséré dans au moins deux feuilles (3, 4), lesquelles présentent respectivement un évidement (10, 11) pour le module (6).

5. Le procédé selon une des revendications 1 à 4, **caractérisé en ce que**, après l'insertion du module (6), au moins une feuille supplémentaire (2) est positionnée, et en particulier deux feuilles supplémentaires (2, 5) sont positionnées sur l'au moins une feuille (3, 4).

6. Support de données en forme de carte ayant un corps de carte (15) et un module (6) implanté dans celui-ci, fabriqué selon une des revendications 1 à 5, **caractérisé en ce que** le corps de carte (15) est comprimé à l'intérieur autour du module (6).

7. Support de données en forme de carte selon la revendication 6, **caractérisé en ce que** le module est inséré dans deux feuilles (3, 4) reliées l'une à l'autre.

8. Support de données en forme de carte selon la revendication 6, **caractérisé en ce que** celui-ci comporte une pluralité de couches est que le module (6) est recouvert d'au moins une feuille (2).
